# EUROPEAN PATENT SPECIFICATION

(11) **EP 3 242 754 B1**
(45) Date of publication and mention of the grant of the patent: **27.03.2019**
(21) Application number: 16702587.3
(22) Date of filing: 08.01.2016
(51) Int. Cl.: B09B 3/00, B09B 5/00, B29B 17/02, B32B 43/00, H01L 31/18, B29C 45/16

(54) **METHOD AND APPARATUS FOR THE DISPOSAL OF PHOTOVOLTAIC PANELS**
VERFAHREN UND VORRICHTUNG ZUR ENTSORGUNG VON FOTOVOLTAIKMODULEN
PROCÉDÉ ET APPAREIL D'ÉLIMINATION DE PANNEAUX PHOTOVOLTAÏQUES

(30) Priority: 08.01.2015 IT MI20150006
(43) Date of publication of application: 15.11.2017
(73) Proprietor: Omizzolo, Giacomo, 31052 Maserada Sul Piave (IT)
(72) Inventor: OMIZZOLO, Fabrizio, 31052 Maserada Sul Piave (IT)
(74) Representative: Modiano, Micaela Nadia
(86) International application number: PCT/IB2016/050090
(87) International publication number: WO 2016/110825

(56) References cited:
- CN-A- 103 978 010
- KR-A- 20140 025 003
- SUKMIN KANG ET AL: "Experimental investigations for recycling of silicon and glass from waste photovoltaic modules", RENEWABLE ENERGY, PERGAMON PRESS, OXFORD, GB, vol. 47, 18 April 2012 (2012-04-18), pages 152-159, XP028510222, ISSN: 0960-1481, DOI: 10.1016/J.RENENE.2012.04.030 [retrieved on 2012-04-26]
- DOI T ET AL: "Experimental study on PV module recycling with organic solvent method", SOLAR ENERGY MATERIALS AND SOLAR CELLS, ELSEVIER SCIENCE PUBLISHERS, AMSTERDAM, NL, vol. 67, no. 1-4, 1 March 2001 (2001-03-01), pages 397-403, XP004224786, ISSN: 0927-0248, DOI: 10.1016/S0927-0248(00)00308-1

## Description

The present invention relates to a method and to an apparatus for the disposal of photovoltaic panels.

Nowadays conventional photovoltaic panels are constituted substantially by an electrically insulating element protecting against atmospheric agents (arranged on the rear side of the panel), by photovoltaic cells (made of mono- or multi-crystalline silicon), by strings (which solder, in series and in pairs, the fronts and backs of adjacent cells), by ribbons which connect the strings in series, by two layers of encapsulating material (usually EVA) which enclose the cells and the strings front and rear, by a flat glass layer that encloses and protects the front side of the panel that faces the sun, and by a frame that encloses the perimeter of the panel.

Conventional panels are therefore constituted by a plurality of components which, structurally, can differ greatly from each other.

Conventional panels suffer a great drawback, which is the disposal thereof at the end of their life.

Given the diversity of the materials used, to date no solution is known which makes it possible to separate and reuse the individual components of the panel, apart from the glass which however must be separated in advance from the plastic material coupled thereto.

Such operation occurs by heating the glass to about 500°C: this entails the emission of toxic gases which must be treated in order to not be introduced into the environment, with consequent increase in costs.

KR 2014 0025003 discloses a method for the disposal of photovoltaic panels but does not disclose pressure control inside a reactor.

Sukmin Kang et al: "Experimental investigations for recycling of silicon and glass from waste photovoltaic modules", Renewable Energy, Pergamon Press, Oxford, GB does not disclose pressure control inside a reactor.

DOI et al: "Experimental study on PV module recycling with organic solvent method", SOLAR ENERGY MATERIALS AND SOLAR CELLS , ELSEVIER SCICENCE PUBLISHERS, AMSTERDAM, NL, vol. 67, no. 1-4 discloses that acetone does not have dissolving power for cross-linked EVA.

The aim of the present invention is to solve the above mentioned technical problems and eliminate the drawbacks in the cited known art by devising a method and an apparatus for the disposal of photovoltaic panels which make it possible to achieve the separation and the reuse of the individual components of the panel.

Within this aim, an object of the invention is to provide a method and an apparatus in which the separation of the individual components of the panel occur without introducing harmful gases or fumes into the environment.

A further object is to provide a method and an apparatus that make it possible to separate the various components of the panel so that they can be reused immediately without having to undergo further processing.

A still further object is to provide a method and an apparatus that require a treatment time of the components which is contained in a few hours.

Another object is to provide a method and an apparatus that can work at temperatures below one hundred degrees centigrade.

Another object is to provide a method and an apparatus that require a very low energy consumption.

Another object is to provide a method and an apparatus that necessitate components that can usually be sourced on the market and which are low cost both to provide and maintain.

This aim and these and other objects which will become better apparent hereinafter are achieved by a method for the disposal of photovoltaic panels, which are constituted by an element protecting against atmospheric agents, by photovoltaic cells, by strings connected with ribbons, by two layers of encapsulating material, by a flat glass layer and by a frame, characterized in that it comprises the following steps:
- loading said photovoltaic panel, from which said frame has previously been removed, into a reactor;
- introducing a mixture based on acetone and ethylene into said reactor;
- hermetically closing said reactor;
- heating diathermic oil to a set temperature and introducing said oil into a pipe coil present in said reactor;
- maintaining said oil at a constant temperature and starting a process of separation of the materials contained in said reactor;
- cooling a condenser for the abatement of the hot vapors emitted by said reactor;
- control the pressure generated inside said reactor by way of a solenoid valve that opens and allows the discharge of said hot vapors which are directed into said condenser inside which they are abated and reconverted to said mixture;
- cooling said reactor and activating an aspiration device which, connected to a carbon filter/expansion vessel, to said condenser and to said reactor, creates the circuit that makes it possible to abate and filter said vapors;
- interrupting the cooling at the end of the chemical reaction inside said reactor and opening said reactor for the extraction of the separated materials at the end of the work cycle and the drying thereof.

Conveniently what is also claimed is an apparatus for the disposal of photovoltaic panels, which are constituted by an element protecting against atmospheric agents, by photovoltaic cells, by strings connected with ribbons, by two layers of encapsulating material, by a flat glass layer and by a frame, characterized in that it comprises:
- a reactor for containing said photovoltaic panel, from which said frame has previously been removed, which contains a mixture based on acetone and ethylene, said reactor being hermetically closeable;
- a basin for heating diathermic oil for sending, at a selected temperature and kept constant, into a pipe coil present in said reactor;
- a refrigeration assembly, connected to a condenser, for cooling said pipe coil present in said reactor;
- a filter/expansion tank, connected to said condenser, and, by way of an aspiration device, to a smokestack, for abating the hot vapors that are emitted by said reactor and in order to recover said mixture;
- a dryer adapted to eliminate the humidity from the separated materials in said reactor at the end of the work cycle and for recovering the residue of said mixture still present in said reactor;
   - non-return valves and automatic on/off valves;
- means for controlling the pressure generated inside said reactor by means of a solenoid valve that opens and allows the discharge of said hot vapors which are directed into said condenser inside which they are abated and reconverted to said mixture.

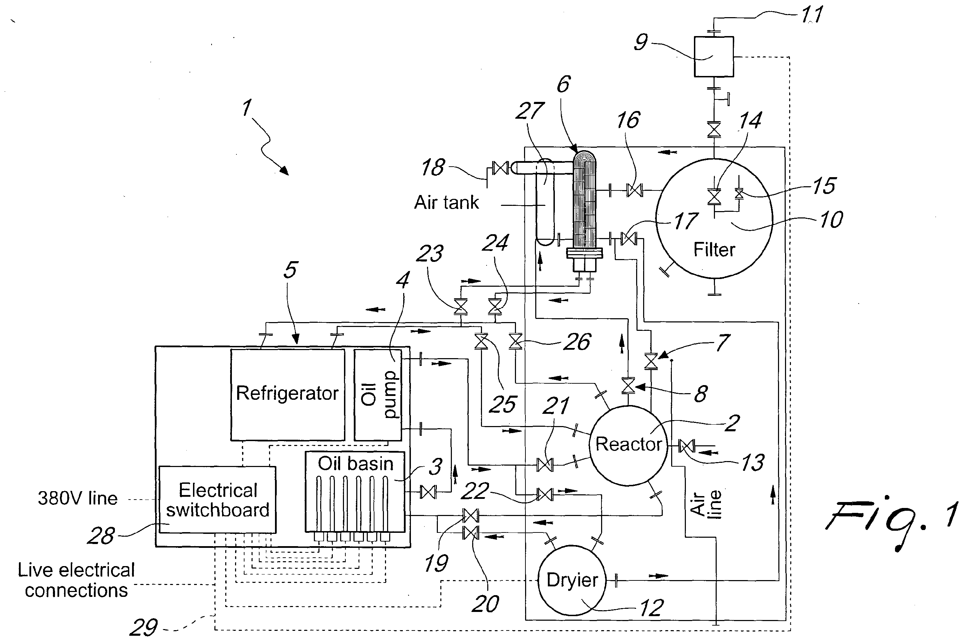

Further characteristics and advantages of the invention will become better apparent from the detailed description of a particular, but not exclusive, embodiment, illustrated by way of non-limiting example in the accompanying drawing wherein Figure 1 is a schematic view of the apparatus.

In the embodiment illustrated, individual characteristics shown in relation to specific examples may in reality be interchanged with other, different characteristics, existing in other exemplary embodiments.

With reference to the figure, the reference numeral 1 generally designates an apparatus for the disposal of photovoltaic panels (not shown), of the type constituted by an element protecting against atmospheric agents, by photovoltaic cells, by strings connected with ribbons, by two layers of encapsulating material, by a flat glass layer and by a frame.

The method has a first step in which the photovoltaic panel, from which the frame has previously been removed, is placed inside a reactor 2; therefore the aluminum profiles are substantially separated from the photovoltaic cells.

The method then has a step in which, before or after the introduction of said photovoltaic panel, a mixture based on acetone and ethylene is placed inside the reactor 2.

The reactor 2 is then closed hermetically so that the substances present inside the reactor 2 are hermetically isolated from the outside environment.

The method then involves heating diathermic oil, which is contained in an adapted basin 3, to a set temperature which is kept constant; this oil is then introduced, by way of an adapted pump 4, into a pipe coil present inside the reactor 2.

Then the step of separation of the materials contained inside the reactor 2 begins.

During the step of separation of the metals, the method involves the activation of a refrigeration assembly 5 which comprises a fridge assembly that, connected to a condenser 6, carries out the cooling of the pipe coil present in the reactor 2.

The pressure generated inside the reactor 2 by raising the temperature of the mixture is controlled by way of a PLC system.

The part of such mixture present in the upper part of the reactor 2 is converted to vapor.

Control of the pressure generated inside the reactor 2 occurs by way of a solenoid valve 7 which opens and allows the discharge of the pressure (hot vapors).

The hot vapors are directed into the condenser 6 inside which they are abated and reconverted to the original chemical mixture, which can therefore be returned to the reactor 2 and therefore reused.

Once the process of separation of the metals is finished, the cycle of cooling the reactor 2 is begun by the refrigeration assembly 5: the discharge valve 8 is opened, and an aspiration device 9 is activated which is connected to a carbon filter/expansion vessel 10 and to the condenser 6 and to the reactor 2, and which creates the circuit that makes it possible to abate and filter the vapors which are created during the chemical process.

The aspiration device 9 is connected to a smokestack 11.

Having reached a selected and adapted temperature for performing the opening of the reactor 2 and therefore to the moment at which the mixture has completed the chemical reaction and does not give off any substance, the cooling stops and the system for opening the reactor 2 is activated.

Only the aspiration device 9 remains switched on and this will be shut down at the end of the operations to extract the materials from the reactor 2.

A dryer 12 is also provided which is adapted to eliminate the humidity from the separated materials in the reactor 2 at the end of the work cycle and is adapted to achieve the recovery of the residue of the mixture still present in the reactor 2.

Obviously there are adapted non-return valves:
13, arranged connected to the reactor 2,
14, 15 arranged inside the filter 10,
16 for connection between the filter 10 and the condenser 6,
17 for connection between the dryer 12 and the condenser 6,
18 connected to the condenser 6 and automatic on/off valves 19, 20, 21, 22,
and other valves 23, 24, 25, 26 which are interposed between the condenser 6, the reactor 2 and the refrigerator 5.

An air tank 27, an electrical switchboard 28 and adapted electrical connections 29 between the various components are also provided.

When the reactor 2 is opened, the materials extracted after the process are substantially constituted by glass, silicon, silver, and lead.

These materials, in a single agglomerate, are placed in the dryer 12 in order to allow the evaporation of the residual chemical mixture.

The vapors obtained are condensed and recovered in liquid (mixture) form which can then be reused.

Thus it has been found that the method and the apparatus fully achieve the intended aim and objects, since it is possible to dispose of photovoltaic panels and in the process recover up to the 95% of the disused materials (glass, silicon, silver, aluminum and other materials in smaller percentages).

Furthermore there is a simplicity and speed in the operations to separate and recover the materials regenerated; there is further a lack, during the process, of toxic and harmful fumes and/or dross. Finally, a reduced energy cost is necessary for the process. Obviously the invention is susceptible of numerous modifications and variations, all of which are within the scope of the appended claims.

Obviously the materials used as well as the dimensions of the
individual components of the invention may be more relevant according to specific requirements.

Where the technical features mentioned in any claim are followed by reference numerals and/or signs, those reference numerals and/or signs have been included for the sole purpose of increasing the intelligibility of the claims and accordingly, such reference numerals and/or signs do not have any limiting effect on the interpretation of each element identified by way of example by such reference numerals and/or signs.

## Claims

1. A method for the disposal of photovoltaic panels, which are constituted by an element protecting against atmospheric agents, by photovoltaic cells, by strings connected with ribbons, by two layers of encapsulating material, by a flat glass layer and by a frame, **characterized in that** it comprises the following steps:
- loading said photovoltaic panel, from which said frame has previously been removed, into a reactor (2);
- introducing a mixture based on acetone and ethylene into said reactor (2);
- hermetically closing said reactor (2);
- heating diathermic oil to a set temperature and introducing said oil into a pipe coil present in said reactor (2);
- maintaining said oil at a constant temperature and starting a process of separation of the materials contained in said reactor (2);
- cooling a condenser (6) for the abatement of the hot vapors emitted by said reactor (2);
- control the pressure generated inside said reactor (2) by way of a solenoid valve that opens and allows the discharge of said hot vapors which are directed into said condenser (6) inside which they are abated and reconverted to said mixture;
- cooling said reactor (2) and activating an aspiration device (9) which, connected to a carbon filter/expansion vessel (10), to said condenser (6) and to said reactor (2), creates the circuit that makes it possible to abate and filter said vapors;
- interrupting the cooling at the end of the chemical reaction inside said reactor (2) and opening said reactor for the extraction of the separated materials at the end of the work cycle and the drying thereof.

2. An apparatus (1) for the disposal of photovoltaic panels, which are constituted by an element protecting against atmospheric agents, by photovoltaic cells, by strings connected with ribbons, by two layers of encapsulating material, by a flat glass layer and by a frame, **characterized in that** it comprises:
- a reactor (2) for containing said photovoltaic panel, from which said frame has previously been removed, which contains a mixture based on acetone and ethylene, said reactor (2) being hermetically closeable;
- a basin (3) for heating diathermic oil for sending, at a selected temperature and kept constant, into a pipe coil present in said reactor (2);
- a refrigeration assembly (5), connected to a condenser (6), for cooling said pipe coil present in said reactor (2);
- a filter/expansion tank (10), connected to said condenser (2), and, by way of an aspiration device (9), to a smokestack (11), for abating the hot vapors that are emitted by said reactor (2) and in order to recover said mixture;
- a dryer (12) adapted to eliminate the humidity from the separated materials in said reactor (2) at the end of the work cycle and for recovering the residue of said mixture still present in said reactor (2);
- non-return valves and automatic on/off valves (13, 14, 15, 16, 17, 18, 19, 20, 21, 22, 23, 24, 25, 26);
- means for controlling the pressure generated inside said reactor by means of a solenoid valve (7) that opens and allows the discharge of said hot vapors which are directed into said condenser inside which they are abated and reconverted to said mixture.

3. The apparatus according to claim 2, **characterized in that** said mixture based on acetone and ethylene is placed inside said reactor (2), after the introduction of said photovoltaic panel, and is kept isolated from the outside environment following the hermetic closing of said reactor (2).

4. The apparatus according to one or more of claims 2 and 3, **characterized in that** said diathermic oil, contained inside said adapted basin (3) and conveniently heated to a set temperature and kept constant, is introduced, by way of an adapted pump (4), into a pipe coil present inside said reactor (2) to cause the start of the step of separation of the materials contained inside said reactor (2).

5. The apparatus according to one or more of claims 2 to 4, **characterized in that** it comprises a refrigeration assembly (5) which comprises a fridge assembly that, connected to a condenser (6), carries out the cooling of said pipe coil present in said reactor (2) during the step of separation of the materials.

6. The apparatus according to one or more of claims 2 to 5, **characterized in that** said means for controlling the pressure generated inside said reactor comprise a PLC system that controls the pressure generated inside said reactor (2) by raising the temperature of said mixture, the part of the latter that is present in the upper part of said reactor (2) being converted to vapor, the control of the pressure generated inside said reactor (2) occurring by way of said solenoid valve (7) which opens and allows the discharge of the pressure (hot vapors).

7. The apparatus according to one or more of claims 2 to 6, **characterized in that** said hot vapors are directed into said condenser (6) inside which they are abated and reconverted to the original chemical mixture, which can therefore be returned to said reactor (2) and therefore reused.

8. The apparatus according to one or more of claims 2 to 7, **characterized in that**, once the process of separation of the metals is finished, said refrigeration assembly (5) starts the cycle of cooling said reactor (2) by opening a discharge valve (8) and activating an aspiration device (9), connected to a smokestack (11) and to said carbon filter/expansion vessel (10) and to said condenser (6) and to said reactor (2), which creates the circuit that makes it possible to abate and filter said vapors which are created during the chemical process.

9. The apparatus according to one or more of claims 2 to 8, **characterized in that**, having reached a selected and adapted temperature at which said mixture has completed the chemical reaction and does not give off any substance, the cooling stops and said reactor (2) is opened, with only the aspiration device (9) remaining switched on, which is shut down at the end of the operations to extract the processed materials from said reactor (2).

10. The apparatus according to one or more of claims 2 to 9, **characterized in that** said dryer (12) is adapted to eliminate the humidity from the separated materials present in said reactor (2) at the end of the work cycle and is adapted to achieve the recovery of the residue of said mixture which is still present in said reactor (2).

## Patentansprüche

1. Ein Verfahren zur Entsorgung von Photovoltaikmodulen, die aus einem Element, das vor atmosphärischen Stoffen schützt, aus Photovoltaikzellen, aus mit Bändern verbundenen Schnüren, aus zwei Schichten Verkapselungsmaterial, aus einer flachen Glasschicht und einem Rahmen bestehen; **dadurch gekennzeichnet, dass** es folgende Schritte umfasst:
- Beladen des Photovoltaikmoduls, von dem der Rahmen zuvor entfernt wurde, in einen Reaktor (2);
- Beförderung einer auf Aceton und Ethylen basierenden Mischung in den Reaktor (2);
- hermetisches Verschließen des Reaktors (2);
- Erhitzen von diathermischem Öl auf eine vordefinierte Temperatur und Beförderung des Öls in eine in dem Reaktor (2) vorhandene Rohrschlange;
- Halten des Öls bei einer konstanten Temperatur und Einleiten eines Prozesses der Trennung der in dem Reaktor (2) enthaltenen Materialien;
- Kühlen eines Kondensators (6) zum Abschwächen der von dem Reaktor (2) emittierten heißen Dämpfe;
- Steuern des innerhalb des Reaktors (2) erzeugten Drucks mit Hilfe eines Magnetventils, das sich öffnet und das Ablassen der heißen Dämpfe ermöglicht, die in den Kondensator (6) gelenkt werden, in welchem sie abgeschwächt und wieder in die Mischung umgewandelt werden;
- Kühlen des Reaktors (2) und Aktivieren einer Ansaugvorrichtung (9) welche, verbunden mit einem Kohlefilter/Expansionsgefäß (10), mit dem Kondensator (6) und mit dem Reaktor (2), den Kreislauf herstellt, der es ermöglicht, die Dämpfe abzuschwächen und zu filtern;
- Unterbrechen des Kühlvorgangs am Ende der chemischen Reaktion in dem Reaktor (2) und Öffnen des Reaktors zur Extraktion der getrennten Materialien am Ende des Arbeitszyklus, und Trocknen derselben.

2. Eine Vorrichtung (1) zur Entsorgung von Photovoltaikmodulen, die aus einem Element, das vor atmosphärischen Stoffen schützt, aus Photovoltaikzellen, aus mit Bändern verbundenen Schnüren, aus zwei Schichten Verkapselungsmaterial, aus einer flachen Glasschicht und einem Rahmen bestehen; **dadurch gekennzeichnet, dass** sie Folgendes umfasst:
- einen Reaktor (2) zum Aufnehmen des Photovoltaikmoduls, von dem der Rahmen zuvor entfernt wurde; welcher eine auf Aceton und Ethylen basierende Mischung enthält, wobei der Reaktor (2) hermetisch verschließbar ist;
- ein Becken (3) zum Erhitzen von diathermischem Öl, um es, bei einer ausgewählten Temperatur, die konstant gehalten wird, in eine in dem Reaktor (2) vorhandenen Rohrschlange zu übertragen;
- einen Kühlaufbau (5), verbunden mit einem Kondensator (6), zum Kühlen der in dem Reaktor (2) vorhandenen Rohrschlange;
- einen Filter/ein Expansionsgefäß (10), verbunden mit dem Kondensator (2) und, über eine Ansaugvorrichtung (9), mit einem Schornstein (11), um die heißen Dämpfe, die von dem Reaktor (2) emittiert werden, abzuschwächen und die Mischung rückzugewinnen;
- einen Trockner (12), ausgebildet, um die Feuchtigkeit am Ende des Arbeitszyklus aus den getrennten Materialien in dem Reaktor (2) zu entfernen und um den Rest der Mischung, der noch in dem Reaktor (2) vorhanden ist, rückzugewinnen;
- Rückschlagventile und automatische Schaltventile (13, 14, 15, 16, 17, 18, 19, 20, 21, 22, 23, 24, 25, 26);
- Mittel zum Steuern des innerhalb des Reaktors erzeugten Drucks mit Hilfe eines Magnetventils (7), das sich öffnet und das Ablassen der heißen Dämpfe ermöglicht, die in den Kondensator gelenkt werden, in welchem sie abgeschwächt und wieder in die Mischung umgewandelt werden.

3. Die Vorrichtung gemäß Anspruch 2, **dadurch gekennzeichnet, dass** die Mischung auf der Grundlage von Aceton und Ethylen nach dem Eintrag des Photovoltaikmoduls in den Reaktor (2) eingebracht und nach dem hermetischen Schließen des Reaktors (2) von der äußeren Umgebung isoliert gehalten wird.

4. Die Vorrichtung gemäß einem oder mehreren der Ansprüche 2 und 3, **dadurch gekennzeichnet, dass** das diathermische Öl, enthalten in dem geeigneten Becken (3) und praktischerweise auf eine voreingestellte Temperatur erhitzt, die konstant gehalten wird, durch eine geeignete Pumpe (4) in ein Schlangenrohr befördert wird, das in dem Reaktor (2) vorhanden ist, um den Schritt der Trennung der in dem Reaktor (2) enthaltenen Materialien einzuleiten.

5. Die Vorrichtung gemäß einem oder mehreren der Ansprüche 2 bis 4, **dadurch gekennzeichnet, dass** sie einen Kühlaufbau (5) umfasst, der einen Kühlschrankaufbau umfasst, welcher, mit einem Kondensator (6) verbunden, während des Schritts der Trennung der Materialien die Kühlung des Schlangenrohrs, das in dem Reaktor (2) vorhanden ist, durchführt.

6. Die Vorrichtung gemäß einem oder mehreren der Ansprüche 2 bis 5, **dadurch gekennzeichnet, dass** die Mittel zum Steuern des innerhalb des Reaktors erzeugten Drucks ein SPS-System umfassen, das den innerhalb des Reaktors (2) erzeugten Druck durch Erhöhung der Temperatur der Mischung steuert; wobei der Teil der Letzteren, der im oberen Teil des Reaktors (2) vorhanden ist, in Dampf umgewandelt wird; wobei die Steuerung des innerhalb des Reaktors (2) erzeugten Drucks durch das Magnetventil (7) erfolgt, das sich öffnet und das Ablassen des Drucks (heißer Dämpfe) ermöglicht.

7. Die Vorrichtung gemäß einem oder mehreren der Ansprüche 2 bis 6, **dadurch gekennzeichnet, dass** die heißen Dämpfe in den Kondensator (6) gelenkt werden, in dem sie abgeschwächt und wieder in die ursprüngliche chemische Mischung umgewandelt werden, welche daher zum Reaktor (2) zurückgeführt und somit wieder verwendet werden kann.

8. Die Vorrichtung gemäß einem oder mehreren der Ansprüche 2 bis 7, **dadurch gekennzeichnet, dass**, sobald der Prozess der Trennung der Metalle abgeschlossen ist, der Kühlaufbau (5) den Kühlzyklus des Reaktors (2) startet durch Öffnen eines Ablassventils (8) und Aktivieren einer Ansaugvorrichtung (9), verbunden mit einem Schornstein (11) und mit dem Kohlefilter/Expansionsgefäß (10) und mit dem Kondensator (6) und mit dem Reaktor (2), der den Kreislauf herstellt, welcher es ermöglicht, die Dämpfe abzuschwächen und zu filtern, die während des chemischen Prozesses erzeugt werden.

9. Die Vorrichtung gemäß einem oder mehreren der Ansprüche 2 bis 8, **dadurch gekennzeichnet, dass**, nachdem eine ausgewählte und geeignete Temperatur erreicht wurde, bei welcher die Mischung die chemische Reaktion abgeschlossen hat und keine Substanz abgibt, der Kühlvorgang beendet und der Reaktor (2) geöffnet wird, wobei nur die Ansaugvorrichtung (9) eingeschaltet bleibt, welche am Ende der Arbeiten ausgeschaltet wird, zum Extrahieren der verarbeiteten Materialien aus dem Reaktor (2) .

10. Die Vorrichtung gemäß einem oder mehreren der Ansprüche 2 bis 9, **dadurch gekennzeichnet, dass** der Trockner (12) ausgebildet ist, um am Ende des Arbeitszyklus die Feuchtigkeit aus den getrennten Materialien zu entfernen, die in dem Reaktor (2) vorhanden sind, und um die Rückgewinnung des Rests der Mischung durchzuführen, die noch in dem Reaktor (2) vorhanden ist.

## Revendications

1. Procédé pour l'élimination de panneaux photovoltaïques, qui sont constitués d'un élément protégeant contre des agents atmosphériques, de cellules photovoltaïques, de cordons reliés avec des rubans, de deux couches de matière d'encapsulation, d'une couche de verre plane et d'un châssis, **caractérisé en ce qu'**il comporte les étapes suivantes consistant à :
- charger ledit panneau photovoltaïque, duquel ledit châssis a été préalablement retiré, dans un réacteur (2),
- introduire un mélange à base d'acétone et d'éthylène dans ledit réacteur (2),
- fermer hermétiquement ledit réacteur (2),
- chauffer de l'huile diathermique jusqu'à une température réglée et introduire ladite huile dans un serpentin présent dans ledit réacteur (2),
- maintenir ladite huile à une température constante et lancer un processus de séparation des matières contenues dans ledit réacteur (2),
- refroidir un condenseur (6) pour la réduction des vapeurs chaudes émises par ledit réacteur (2),
- réguler la pression générée à l'intérieur dudit réacteur (2) au moyen d'une électrovanne qui s'ouvre et permet la décharge desdites vapeurs chaudes qui sont dirigées dans ledit condenseur (6) à l'intérieur duquel elles sont réduites et reconverties en dit mélange,
- refroidir ledit réacteur (2) et activer un dispositif d'aspiration (9) qui, relié à un filtre à charbon/vase d'expansion (10), audit condenseur (6) et audit réacteur (2), crée le circuit qui permet de réduire et de filtrer lesdites vapeurs,
- interrompre le refroidissement à la fin de la réaction chimique à l'intérieur dudit réacteur (2) et ouvrir ledit réacteur pour l'extraction des matières séparées à la fin du cycle de travail et le séchage de celles-ci.

2. Appareil (1) pour l'élimination de panneaux photovoltaïques, qui sont constitués d'un élément protégeant contre des agents atmosphériques, de cellules photovoltaïques, de cordons reliés avec des rubans, de deux couches de matière d'encapsulation, d'une couche de verre plane et d'un châssis, **caractérisé en ce qu'**il comporte :
- un réacteur (2) pour contenir ledit panneau photovoltaïque, duquel ledit châssis a été préalablement retiré, qui contient un mélange à base d'acétone et d'éthylène, ledit réacteur (2) pouvant être fermé hermétiquement,
- un bac (3) pour chauffer de l'huile diathermique pour l'envoyer, à une température sélectionnée et maintenue constante, dans un serpentin présent dans ledit réacteur (2),
- un ensemble de réfrigération (5), relié à un condenseur (6), pour refroidir ledit serpentin présent dans ledit réacteur (2),
- un filtre/vase d'expansion (10), relié audit condenseur (3), et, au moyen d'un dispositif d'aspiration (2), à une cheminée industrielle (11), pour réduire les vapeurs chaudes qui sont émises par ledit réacteur (2) et afin de récupérer ledit mélange,
- un sécheur (12) adapté pour éliminer l'humidité provenant des matières séparées dans ledit réacteur (2) à la fin du cycle de travail et pour récupérer le résidu dudit mélange encore présent dans ledit réacteur (2),
- des clapets anti-retour et des vannes de marche-arrêt automatiques (13, 14, 15, 16, 17, 18, 19, 20, 21, 22, 23, 24, 25, 26),
- des moyens pour réguler la pression générée à l'intérieur dudit réacteur au moyen d'une électrovanne (7) qui s'ouvre et permet la décharge desdites vapeurs chaudes qui sont dirigées dans ledit condenseur à l'intérieur duquel elles sont réduites et reconverties en dit mélange.

3. Appareil selon la revendication 2, **caractérisé en ce que** ledit mélange à base d'acétone et d'éthylène est placé à l'intérieur dudit réacteur (2), après l'introduction dudit panneau photovoltaïque, et est maintenu isolé de l'environnement extérieur après la fermeture hermétique dudit réacteur (2).

4. Appareil selon une ou plusieurs des revendications 2 et 3, **caractérisé en ce que** ladite huile diathermique, contenue à l'intérieur dudit bac (3) adapté et chauffée de manière pratique jusqu'à une température réglée et maintenue constante, est introduite, au moyen d'une pompe (4) adaptée, dans un serpentin présent à l'intérieur dudit réacteur (2) pour provoquer le début de l'étape de séparation des matières contenues à l'intérieur dudit réacteur (2).

5. Appareil selon une ou plusieurs des revendications 2 à 4, **caractérisé en ce qu'**il comporte un ensemble de réfrigération (5) qui comporte un ensemble de réfrigérateur qui, relié à un condenseur (6), exécute le refroidissement dudit serpentin présent dans ledit réacteur (2) pendant l'étape de séparation des matières.

6. Appareil selon une ou plusieurs des revendications 2 à 5, **caractérisé en ce que** lesdits moyens pour réguler la pression générée à l'intérieur dudit réacteur comportent un système PLC qui régule la pression générée à l'intérieur dudit réacteur (2) en augmentant la température dudit mélange, la partie de ce dernier qui est présente dans la partie supérieure dudit réacteur (2) étant convertie en vapeur, la régulation de la pression générée à l'intérieur dudit réacteur (2) ayant lieu au moyen de ladite électrovanne (7) qui s'ouvre et permet la décharge de la pression (vapeurs chaudes).

7. Appareil selon une ou plusieurs des revendications 2 à 6, **caractérisé en ce que** lesdites vapeurs chaudes sont dirigées dans ledit condenseur (6) à l'intérieur duquel elles sont réduites et reconverties en mélange chimique d'origine, qui peut donc être renvoyé audit réacteur (2) et donc être réutilisé.

8. Appareil selon une ou plusieurs des revendications 2 à 7, **caractérisé en ce que**, une fois que le processus de séparation des métaux est terminé, ledit ensemble de réfrigération (5) lance le cycle de refroidissement dudit réacteur (2) en ouvrant une vanne de décharge (8) et en activant un dispositif d'aspiration (9), relié à une cheminée industrielle (11) et audit filtre à charbon/vase d'expansion (10) et audit condenseur (6) et audit réacteur (2), ce qui crée le circuit qui permet de réduire et de filtrer lesdites vapeurs qui sont créées pendant le processus chimique.

9. Appareil selon une ou plusieurs des revendications 2 à 8, **caractérisé en ce que**, après avoir atteint une température sélectionnée et adaptée à laquelle ledit mélange a terminé la réaction chimique et ne libère aucune substance, le refroidissement s'arrête et ledit réacteur (2) est ouvert, avec uniquement le dispositif d'aspiration (9) restant en marche, qui est arrêté à la fin des opérations pour extraire dudit réacteur (2) les matières traitées.

10. Appareil selon une ou plusieurs des revendications 2 à 9, **caractérisé en ce que** ledit sécheur (12) est adapté pour éliminer l'humidité des matières séparées présentes dans ledit réacteur (2) à la fin du cycle de travail et est adapté pour obtenir la récupération du résidu dudit mélange qui est encore présent dans ledit réacteur (2).
